# EUROPEAN PATENT APPLICATION

(11) **EP 3 869 633 A1**
(43) Date of publication of application: **25.08.2021**
(21) Application number: 20159022.1
(22) Date of filing: 24.02.2020
(51) Int. Cl.: H01R 13/66, H01R 13/713, H01R 24/76, G01S 15/89, H03K 17/95, G01S 15/04, G01S 15/88, G01S 7/539

(54) **SYSTEM AND METHOD FOR CONTROLLING A POWER SOCKET**

(71) Applicant: Vestel Elektronik Sanayi ve Ticaret A.S., 45030 Manisa (TR)
(72) Inventor: AKDEMIR, Onur, 45030 Manisa (TR); ÖZMEN, Ferhat, 45030 Manisa (TR)
(74) Representative: Kehl, Ascherl, Liebhoff & Ettmayr Patentanwälte Partnerschaft mbB

(57) **Abstract**

The present invention refers to a system for controlling a power socket (1). The system comprises according to the invention a power socket (1) forming at least one power outlet (2) for receiving a corresponding power inlet (4), a sensor (6) for sensing presence of an object (8), wherein the sensor (6) outputs sensing data and/or sensing signals representing presence of the object (8) in a sensing range of the sensor (6), an ultrasonic transmitter (10) for emitting ultrasonic waves in dependency of the detection data and/or detection signals, an ultrasonic receiver (12) for receiving ultrasonic waves outputted by the ultrasonic transmitter and at least partially reflected by the object (8), wherein the ultrasonic receiver (12) outputs detection data and/or detection signals, a power providing and/or cutting off unit (14) and a comparator unit (16) for comparing the detection data and/or detection signals with reference data and/or reference signals, wherein the comparator unit (16) controls the power providing and/or cutting off unit (14), wherein the power providing and/or cutting off unit (14) cuts of power flow in case detection data and/or detection signals differ from the reference data and/or reference signals or wherein the power providing and/or cutting off unit (14) starts enabling power flow to the power outlet (2) in case the detection data and/or detection signals match with the reference data and/or reference signals.

## Description

The present invention refers according to claim 1 to a system for controlling a power socket, according to claims 7 and 8 to methods for controlling a power socket and according to claim 15 to a power socket.

### BACKGROUND OF THE INVENTION

Today, electrical outlets used in domestic environments bring many hazards periodically.
For example, curious discovery periods of young children. During these periods, children may insert objects (made of metal etc.) that they find in homes into the electrical sockets, which may result in serious injury or death.

There are some systems that detect objects on the power outlet. These systems have an alarm system or power cut system. Such systems are mechanical system or RFID systems.

### OBJECT OF THE INVENTION

Thus, it is the object of the invention to provide a comfortable and save power socket.

### DESCRIPTION OF THE INVENTION

The before mentioned object is solved by a system for controlling a power socket according to claim 1. The system according to the invention at least comprises a power socket forming at least one power outlet for receiving a corresponding power inlet, a sensor for sensing presence of an object, wherein the sensor outputs sensing data and/or sensing signals representing presence of the object in a sensing range of the sensor, an ultrasonic transmitter for emitting ultrasonic waves in dependency of the detection data and/or detection signals, an ultrasonic receiver for receiving ultrasonic waves outputted by the ultrasonic transmitter and at least partially reflected by the object, wherein the ultrasonic receiver outputs detection data and/or detection signals, a power providing and/or cutting off unit and a comparator unit for comparing the detection data and/or detection signals with reference data and/or reference signals, wherein the comparator unit controls the power providing and/or cutting off unit. Thus, the comparator preferably compares detection data and reference data and/or detection signals and reference signals. The power providing and/or cutting off unit cuts of power flow respectively prevents providing power to a power output in case detection data and/or detection signals differ from the reference data and/or reference signals. Additionally, or alternatively the power providing and/or cutting off unit starts enabling power flow to the power outlet respectively enables providing power to the power output in case the detection data and/or detection signals match with the reference data and/or reference signals. Thus, the invention preferably utilizes an ultrasonic sensor system on smart outlet system.
This solution is beneficial, since the socket does not provide any danger anymore, since power is only provided respectively switched on respectively not switched off in case the object is identified as power plug. Former methods or systems do not solve the problem as easy as the present solution.
Thus, a protection and early warning system is provided in order to prevent the dangerous situation that may be caused by inserting an object (which is not designed to be put into an electric outlet) into an electrical outlet. Therefore, the electrical outlets respectively power sockets according to the present invention reduce the risks which come with power outlets significantly.
Further preferred embodiments are described in the following specification parts.
According to a further preferred embodiment of the present invention reference data and/or reference signals represent a reflection pattern of ultrasonic waves, wherein the reflection pattern represents ultrasonic waves reflected by a reference object, wherein the reference object is a power plug, wherein the power plug has at least or exactly two metal pins or at least or exactly three metal pins or up to two or up to three metal pins. The metal pin/s is/are preferably considered as power inlet. It is also possible that reference data and/or reference signals are provided which represent multiple reflection patterns of ultrasonic waves and therefore represent multiple different reference object, wherein said reference objects are preferably power plugs. This embodiment is beneficial since due to objects different from power plugs, like a ball pen or a fork, power is switched off respectively not switched on. Thus, the power socket comprises high comfort, since power is provided in case a power plug is positioned in front of the power socket. Furthermore, no manual adjustment is necessary, thus parents do not always have to switch the power socket on or off.
The sensor is according to a further preferred embodiment of the present invention an inductive proximity sensor or metal detector or optical sensor, wherein the inductive proximity sensor or metal detector or optical sensor is part of the power socket or wherein the inductive proximity sensor or metal detector or optical sensor is coupled to the power socket. This embodiment is beneficial since material is detectable which has electric conductivity, in particularly an electric conductivity higher than 0,5 · 10⁻⁶ *σ* in S/m or higher than 0,5 · 10⁻³ *σ* in S/m or higher than 0,5 · 10° *σ* in S/m or higher than 0,5 · 10² *σ* in S/m.

According to a further preferred embodiment of the present invention the power plug is a power plug of the type: TIS 166-2549, SANS 164-2 3-pin, SANS 164-2 2-pin, NBR 14136 3-pin, NBR 14136 2-pin, IS 1293 and SANS 164-1, BS 546, CEI 23-50 (formerly CEI 23-16). 107-2-D1, SEV 1011:2009, Type 12 plug, IRAM 2073, GB 1002 and GB 2099.1, AS/NZS 3112, SI 32, BS 1363, IS 401 & IS 411, MS 589, SS 145, CEE 7/7 plug, CEE 7/4 plug, CEE 7/6 plug, IS 1293 and SANS 164-3, BS 4573, GOST 7396 C 1, CEE 7/2 plug, CEE 7/17 plug, CEE 7/16, JIS C 8303 Class I, NEMA 5-20, NEMA 5-15, JIS C 8303 Class II, NEMA 1-15 polarized or NEMA 1-15 unpolarized. In particularly CEE 7/16 and/or CEE 7/17 plug and/or CEE 7/4 plug and/or CEI 23-50 and/or BS 1363. This embodiment is beneficial since one or multiple of the before mentioned plugs can be identified by means of the comparator unit.

According to a further preferred embodiment of the present invention the comparator unit is an operational amplifier (respectively opamps) unit, respectively an operational amplifier circuit or comprises an opamps unit respectively an operational amplifier circuit. This embodiment is beneficial since the comparator produces an output potential which is larger than the potential differences between the input terminals, in particularly two or more than two times larger or 20 times or more than twenty times larger or fifty times or more than fifty times larger.

According to a further preferred embodiment of the present invention the power providing and/or cutting off unit is a relay unit or comprises a relay unit. This embodiment is beneficial since power can be provided by establishing a power connection by means of the relay respectively by switching the relay in a connection state or an established power connection can be interrupted by means of the relay respectively power can be cut off by switching the relay in a disconnected state.

The above-mentioned object is also solved by a method for controlling a power socket according to claim 7 respectively a method of a smart power outlet. The method according to the invention preferably comprises at least the steps: Operating a sensor for sensing presence of an object in a sensing range, wherein the sensor is part of the power socket or coupled with the power socket; preferably activating an ultrasonic transmitter and an ultrasonic receiver; Operating the ultrasonic transmitter in case the object is sensed by the sensor, wherein the ultrasonic transmitter and/or the ultrasonic receiver is part of the power socket or electrically coupled with the power socket, wherein the ultrasonic transmitter emits ultrasonic waves; Operating the ultrasonic receiver, wherein the ultrasonic receiver receives ultrasonic waves emitted by the ultrasonic transmitter and at least partly reflected by the object, wherein the ultrasonic receiver outputs detection data and/or detection signals representing the received ultrasonic waves; Operating a comparator unit, wherein the comparator unit compares the detection data and/or detection signals outputted by the ultrasonic receiver with reference data and/or reference signals; Operating a power providing and/or cutting off unit, wherein the power providing and/or cutting off unit is part of the power socket or electrically coupled with the power socket. The power providing and/or cutting off unit preferably cuts off the power provided to at least one power outlet of the power socket in case the detection data and/or detection signals differ from the reference data and/or reference signals. Alternatively, the power providing and/or cutting off unit preferably activates power delivery to at least one power outlet of the power socket in case the detection data and/or detection signals match with the reference data and/or reference signals.
This method is beneficial, since it provides steps that cause a reduction of risk in view of power sockets.
The above-mentioned object is also solved by a method for controlling a power socket according to claim 8 respectively a method of a smart power outlet. The method according to the invention preferably comprises at least the steps: Operating a sensor for sensing presence of an object in a sensing range, wherein the sensor is part of the power socket or coupled with the power socket; preferably activating an ultrasonic transmitter and an ultrasonic receiver; Operating the ultrasonic transmitter in case the object is sensed by the sensor, wherein the ultrasonic transmitter and/or the ultrasonic receiver is part of the power socket or electrically coupled with the power socket, wherein the ultrasonic transmitter emits ultrasonic waves; Operating the ultrasonic receiver, wherein the ultrasonic receiver receives ultrasonic waves emitted by the ultrasonic transmitter and at least partly reflected by the object, wherein the ultrasonic receiver outputs detection data and/or detection signals representing the received ultrasonic waves; Operating a comparator unit, wherein the comparator unit compares the detection data and/or detection signals outputted by the ultrasonic receiver with reference data and/or reference signals; Operating a power providing and/or cutting off unit, wherein the power providing and/or cutting off unit is part of the power socket or electrically coupled with the power socket. The power providing and/or cutting off unit preferably enables power provided to at least one power outlet of the power socket in case the detection data and/or detection signals match with the reference data and/or reference signals. Alternatively, the power providing and/or cutting off unit preferably prevents activation of power delivery to the power outlet, in case the detection data and/or detection signals differ from the reference data and/or reference signals.
This method is beneficial, since it provides steps that cause a reduction of risk in view of power sockets.
According to a preferred embodiment of the present method reference data and/or reference signals represent a reflection pattern of ultrasonic waves, wherein the reflection pattern represents ultrasonic waves reflected by a reference object, wherein the reference object is a power plug, wherein the power plug has at least or exactly two metal pins or at least or exactly three metal pins or up to two or up to three metal pins. It is also possible that reference data and/or reference signals are provided which represent multiple reflection patterns of ultrasonic waves and therefore represent multiple different reference object, wherein said reference objects are preferably power plugs. This embodiment is beneficial since due to objects different from power plugs, like a ball pen or a fork, power is switched off respectively not switched on. Thus, the power socket comprises high comfort, since power is provided in case a power plug is positioned in front of the power socket. Furthermore, no manual adjustment is necessary, thus parents do not always have to switch the power socket on or off.
The sensor is according to a further preferred embodiment of the present method an inductive proximity sensor or metal detector or optical sensor, wherein the inductive proximity sensor or metal detector or optical sensor is part of the power socket or wherein the inductive proximity sensor or metal detector or optical sensor is coupled to the power socket. This embodiment is beneficial since material is detectable which has electric conductivity, in particularly an electric conductivity higher than 0,5 · 10⁻⁶ *σ* in S/m or higher than 0,5 · 10⁻³ *σ* in S/m or higher than 0,5 · 10⁰ *σ* in S/m or higher than 0,5 · 10² *σ* in S/m.
According to a further preferred embodiment of the present method the power plug is a power plug of the type: TIS 166-2549, SANS 164-2 3-pin, SANS 164-2 2-pin, NBR 14136 3-pin, NBR 14136 2-pin, IS 1293 and SANS 164-1, BS 546, CEI 23-50 (formerly CEI 23-16), 107-2-D1, SEV 1011:2009, Type 12 plug, IRAM 2073, GB 1002 and GB 2099.1, AS/NZS 3112, SI 32, BS 1363, IS 401 & IS 411, MS 589, SS 145, CEE 7/7 plug, CEE 7/4 plug, CEE 7/6 plug, IS 1293 and SANS 164-3, BS 4573, GOST 7396 C 1, CEE 7/2 plug, CEE 7/17 plug, CEE 7/16, JIS C 8303 Class I, NEMA 5-20, NEMA 5-15, JIS C 8303 Class II, NEMA 1-15 polarized or NEMA 1-15 unpolarized. In particularly CEE 7/16 and/or CEE 7/17 plug and/or CEE 7/4 plug and/or CEI 23-50 and/or BS 1363. This embodiment is beneficial since one or multiple of the before mentioned plugs can be identified by means of the comparator unit.
According to a further preferred embodiment of the present method the comparator unit is an operational amplifier (respectively opamps) unit, respectively an operational amplifier circuit. This embodiment is beneficial since the comparator produces an output potential which is larger than the potential differences between the input terminals, in particularly two or more than two times larger or 20 times or more than twenty times larger or fifty times or more than fifty times larger.
According to a further preferred embodiment of the present method the power providing and/or cutting off unit is a relay unit. This embodiment is beneficial since power can be provided by establishing a power connection by means of the relay respectively by switching the relay in a connection state or an established power connection can be interrupted by means of the relay respectively power can be cut off by switching the relay in a disconnected state.
According to a further preferred embodiment of the present invention a step of outputting of an acoustic signal in case power is cut off by the power providing and/or cut off unit and/or outputting an optical signal in case power is cut off by the power providing and/or cut off unit is provided. Thus, the present system and/or power socket preferably comprises at least one or exactly one, in particularly two or more than two or multiple, acoustic signal outputting unit, in particularly an acoustic signal outputting circuit and/or speaker. Additionally or alternatively the power socket or system according to the present invention preferably comprises at least one or exactly one, in particularly two or more than two or multiple, optical respectively visual outputting unit, in particularly an optical respectively visual outputting circuit and/or a display and/or one ore multiple light sources, in particular LCD, LED or OLED. It is additionally or alternatively possible that the present invention comprises the step of outputting an acoustic signal in case the power delivery is activated and/or outputting an optical signal in case the power delivery is activated.

According to a further preferred embodiment of the present invention a step of transmitting alert data via a wireless data connection to a mobile device, in particularly a smart phone or Tablet PC or smart watch, is provided in case the power providing and/or cutting off unit cuts off providing power to the power socket and/or a server unit, in particularly a cloud server, wherein the power socket is preferably coupled with a wireless data transmitter, in particularly a Bluetooth transmitter or a WLAN transmitter, or wherein the power socket comprises a wireless data transmitter, in particularly a Bluetooth transmitter or a WLAN transmitter. Additionally or alternatively a step of transmitting via a wireless data connection connecting data to a mobile device, in particularly a smart phone or Tablet PC or smart watch, and/or a server unit, in particularly a cloud server, is provided in case the power providing and/or cutting off unit provides power to the power socket, wherein the power socket is preferably coupled with a wireless data transmitter, in particularly a Bluetooth transmitter or a WLAN transmitter, or wherein the power socket comprises a wireless data transmitter, in particularly a Bluetooth transmitter or a WLAN transmitter.
According to a further preferred embodiment of the present invention the comparator unit is preferably an opamp circuit and wherein the power providing and/or cutting off unit is a relay unit and wherein the acoustic signals are outputted by an acoustic signal outputting unit, which is part of the power socket or which is coupled with the power socket.
The above-mentioned object is also solved by a power socket according to claim 15. The power socket according to the present invention preferably comprises a sensor for sensing presence of an object, wherein the sensor outputs sensing data and/or sensing signals representing presence of the object in a sensing range of the sensor in case the object is sensed in the sensing range, an ultrasonic transmitter for emitting ultrasonic waves in dependency of the detection data and/or detection signals, an ultrasonic receiver for receiving ultrasonic waves outputted by the ultrasonic transmitter and at least partially reflected by the object, wherein the ultrasonic receiver outputs detection data and/or detection signals, a power providing and/or cutting off unit and a comparator unit for comparing the detection data and/or detection signals with reference data and/or reference signals, wherein the comparator unit controls the power providing and/or cutting off unit, wherein the power providing and/or cutting off unit cuts of power flow in case detection data and/or detection signals differ from the reference data and/or reference signals or wherein the power providing and/or cutting off unit starts enabling power flow to the power outlet in case the detection data and/or detection signals match with the reference data and/or reference signals.
Thus, the invention preferably comprises at least one ultrasonic transmitter and receiver, a comparator unit, in particularly a comparator opamps circuit, a sensor, in particularly an inductive proximity sensor, a power providing and/or cutting off unit, in particularly a relay circuit. Furthermore, the power socket or system according to the present invention might comprises an audible warning circuit and/or an optical respectively visual warning circuit (or display or light emitting means) and/or a wireless data transmitter.
The power sockets according to the present invention can be used in sockets in any home, work and/or office environment.
Further benefits, goals and features of the present invention will be described by the following specification of the attached figure, in which exemplarily components of the invention are illustrated. Components of the device or system and methods according to the invention, which match at least essentially with respect to their function can be marked with the same reference sign, wherein such components do not have to be marked or described multiple times with respect to said figures. In the following the invention is just exemplarily described with respect to the attached figures.

### BRIEF DESCRIPTION OF THE DRAWINGS

For a more complete understanding of the present invention and advantages thereof, reference is now made to the following description taken in conjunction with the accompanying drawings. The invention is explained in more detail below using an exemplary embodiment which is specified in the schematic figures of the drawings, in which:
- Fig. 1: shows schematically an example of a power socket according to the present invention,
- Fig. 2: shows schematically an example of a multi socket according to the present invention,
- Fig. 3: shows schematically a further example of a multi socket according to the present invention, and
- Fig. 4: shows schematically a further example of a multi socket according to the present invention.

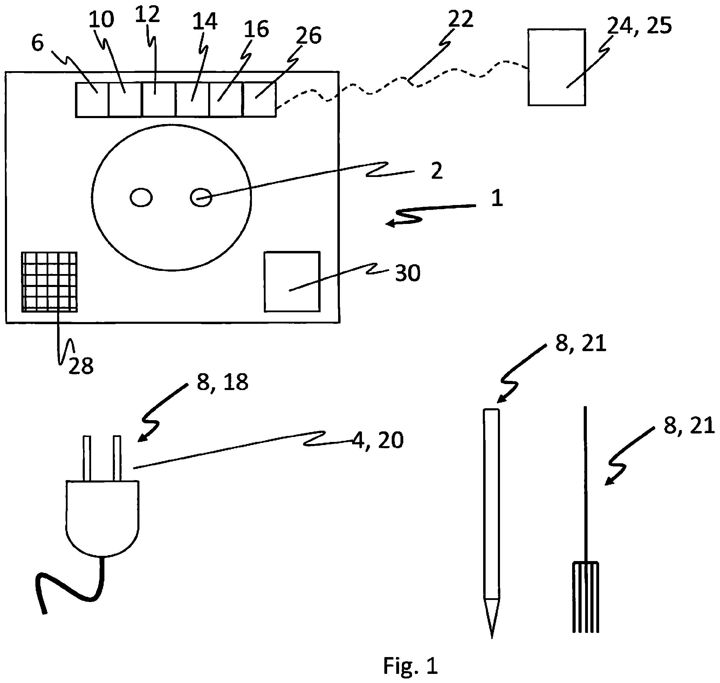

Fig. 1 shows a power socket 1 according to the present invention. Said power socket 1 comprises a sensor 6 for sensing presence of an object 8, wherein the sensor 6 outputs sensing data and/or sensing signals representing presence of the object 8 in a sensing range of the sensor 6 in case the object 8 is sensed in the sensing range. Reference number 2 indicates a power socket 1, which further comprises an ultrasonic transmitter 10 for emitting ultrasonic waves in dependency of the detection data and/or detection signals and an ultrasonic receiver 12 for receiving ultrasonic waves outputted by the ultrasonic transmitter 10 and at least partially reflected by the object 8, wherein the ultrasonic receiver 12 outputs detection data and/or detection signals. The power socket 1 further comprises a power providing and/or cutting off unit 14 and a comparator unit 16 for comparing the detection data and/or detection signals with reference data and/or reference signals, wherein the comparator unit 16 controls the power providing and/or cutting off unit 14. The power providing and/or cutting off unit 14 preferably cuts of power flow in case detection data and/or detection signals differ from the reference data and/or reference signals. Alternatively, the power providing and/or cutting off unit 14 starts enabling power flow to the power outlet 12 in case the detection data and/or detection signals match with the reference data and/or reference signals.

The inventive power socket 1 respectively the inventive system preferably operates according to the logic described in the following:
When the electrical outlet 2 is active, a sound wave is sent from the holes of the electrical outlet 2 to the outside via the ultrasonic transmitter 10. Thus, the ultrasonic transmitter is preferably arranged close to the outlet 2 respectively close to the outlets 2 and preferably inside a housing or on a "wall-side" in case the power socket is a stationary power socket. However, it is also possible that the ultrasonic transmitter is arranged on the "outside" respectively outside of a housing. At the same time, one or multiple ultrasonic receiver 12 respectively ultrasonic receiver sensors 12 that are able to detect these sound waves, in particularly reflected sound waves, is/are activated respectively operated. In addition, the sensor 6, in particularly an inductive proximity sensor, which will detect the objects 8, 18, 21 approaching the electrical outlet 2, will be activated respectively operated.

If the object 8, 18, 21 approaching the electrical outlet 2 is preferably made of an electrically conductive material, this object 8, 18, 21 will be detected as soon as it enters the sensing range of the sensor 6, in particularly inductive proximity sensor 6.

The sound wave, which is preferably sent from the holes of the electrical outlet 2 to the outside via the ultrasonic transmitter 10 and received back after impacting the object 8, 18, 21, is identified via a comparator unit 16, in particularly an opamp circuit. The comparator unit, in particularly opamp circuit, is preferably designed in dependency of reflected sound waves which are reflected by one or multiple specific power plug/s.

The sound signal differences are compared. If the difference is equal, the approaching object 8 will be perceived as a predefined power plug 18, in particularly a two-pin plug 18, so that it does not pose danger and thus power will not be cut off. Reference number 20 indicates a pin of the power plug 8, 18, wherein the pin 20 can be considered as power inlet 4. The outlet 2 remains active respectively is switched on. In case the received signal does not match with the predefined signal the outlet 2 remains inactive respectively is switched off.

Reference number 21 indicates as example two metal objects 8, in particularly a ball pen 21 and a fork 21. In case someone tries to put an object 8, 21 different from a predefined power plug 8, 18 into the power outlet 2 according to the invention the risk of danger is reduced since power is switched off respectively power remains switched off. In other words: if an object 8, 21 other than a plug 8, 18, such as tweezers, is inserted into the electrical outlet 2, the short-circuit current that will occur will trigger the relay power cut off circuit and the power will be cut off. In case a signal difference is perceived by the comparator unit, in particularly by the opamp circuit, the power is cut off respectively remains switched of and preferably an acoustic buzzer and/or a visual indication will be activated by a warning circuit, in particularly an acoustic warning unit 28 and/or visual warning unit 30.

Optionally a data and/or signal connection 22 to a further device, in particularly a server 25 and/or mobile device 24, in particularly smart phone or tablet PC or smart watch, can be established. Said connection 22 is preferably a wireless data connection. Thus, the power socket 1 preferably also comprises a wireless data transmitter 26.

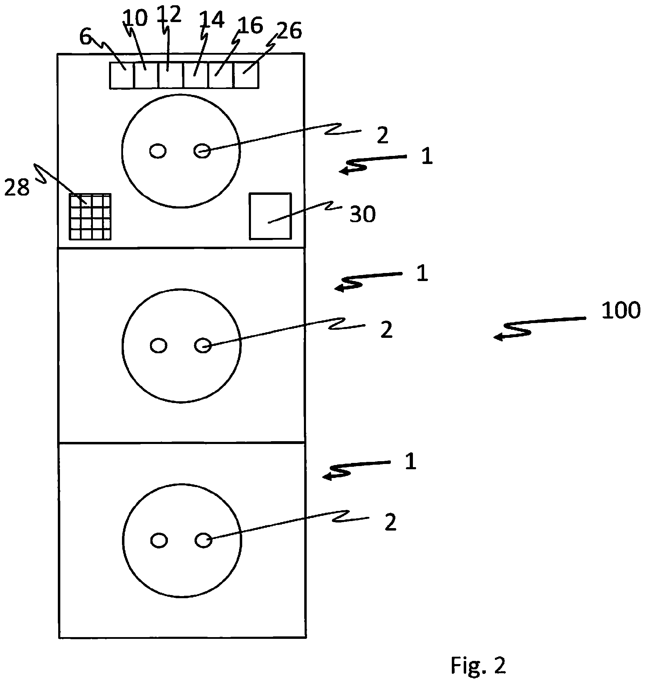

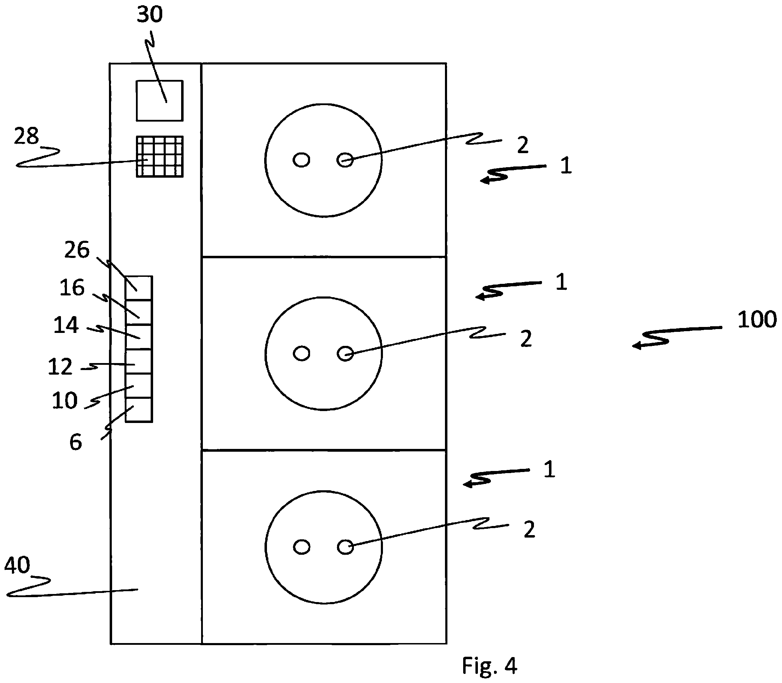

Fig. 2, fig. 3 and fig. 4 show further preferred embodiments of the present invention. According to these embodiments the power socket 2 comprises multiple power outlets 2. Reference number 100 indicates a multi power outlet socket.

These embodiments are beneficial since multiple power outlets 2, in particular for coupling with two or more than two power plugs 18 at the same time, in particularly for coupling with up to 3 or 5 or 10 or 15 or 20 or 30 plugs at the same time, are provided. It is possible that one sensor 6 and/or one ultrasonic transmitter 10 and/or ultrasonic receiver 12 is provided for multiple, in particularly two or three or up to three or up to five or all, power outlets 2. Thus, it is also possible that one or multiple sensors 6 and/or one or multiple ultrasonic transmitters 10 and/or one or multiple ultrasonic receivers 12 and/or one or multiple comparators 16 and/or one or multiple power providing and/or cutting off unit 14 and/or one or multiple acoustic signal units 28 and/or one or multiple visual signal units 30 are provided in case the power socket 1 comprises multiple power outlets 2 for coupling with multiple power plugs 18 at the same time. Additionally, or alternatively it is possible that one power outlet 2 is defined as master power outlet and the other power outlets of the power socket are defined as slave outlets. Additionally, or alternatively the power providing and/or cutting off unit/s 14 cut/s power supply to all power outlets 2 of one power socket 1, in case the power providing and/or cutting off unit/s cut/s power. Additionally, or alternatively the power providing and/or cutting off unit/s 14 cuts power supply only to such power outlets 2 which are not coupled with a power plug 18, in case the power providing and/or cutting off unit/s 14 cut/s power.

According to Fig. 2 the multi socket 100 comprises only one sensor 6, ultrasonic transmitter 10, ultrasonic receiver 12, power providing and/or cutting off unit 14 and comparator unit 16. Furthermore, the multi socket 100 preferably comprises one or only one speaker respectively acoustical signal unit 28 and/or one or only one optical respectively visual display or signal unit 30.

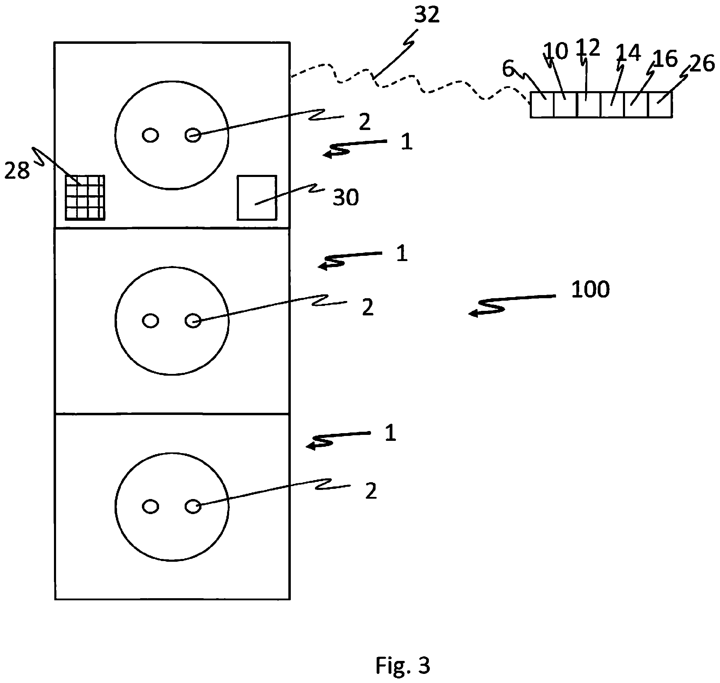

According to Fig. 3 at least one and preferably multiple of the following units: sensor 6, ultrasonic transmitter 10, ultrasonic receiver 12, power providing and/or cutting off unit 14 and comparator unit 16 is/are arranged in a housing different to the housing of the multi socket 100. Said unit/s are preferably functionally, in particularly signally and/or electrically and/or mechanically, coupled with the multi socket 100.

According to Fig. 3 at least one and preferably multiple of the following units: sensor 6, ultrasonic transmitter 10, ultrasonic receiver 12, power providing and/or cutting off unit 14 and comparator unit 16 is/are arranged in or on a main board 40 or main section or common section of multi socket 100.

Multi socket 100 can comprise a power plug for electrically connecting the power outlets 2 of said multi socket 100 with a power outlet of another power socket.

Alternatively, multi socket 100 can comprise connection members for electrically connecting the power outlets 2 of said multi socket 100 with a grid or power source.

Thus, the present invention refers to a system for controlling a power socket 1, said system preferably comprises at least a power socket 1, in particularly a multi socket 100, forming at least one power outlet 2 and preferably multiple power outlets 2 for receiving a corresponding power inlet 4, a sensor 6 for sensing presence of an object 8, wherein the sensor 6 outputs sensing data and/or sensing signals representing presence of the object 8 in a sensing range of the sensor 6, an ultrasonic transmitter 10 for emitting ultrasonic waves in dependency of the detection data and/or detection signals, an ultrasonic receiver 12 for receiving ultrasonic waves outputted by the ultrasonic transmitter and at least partially reflected by the object 8, wherein the ultrasonic receiver 12 outputs detection data and/or detection signals, a power providing and/or cutting off unit 14 and a comparator unit 16 for comparing the detection data and/or detection signals with reference data and/or reference signals, wherein the comparator unit 16 controls the power providing and/or cutting off unit 14, wherein the power providing and/or cutting off unit 14 cuts of power flow in case detection data and/or detection signals differ from the reference data and/or reference signals or wherein the power providing and/or cutting off unit 14 starts enabling power flow to the power outlet 2 in case the detection data and/or detection signals match with the reference data and/or reference signals.

### LIST OF REFERENCE NUMBERS

- 1: power socket
- 2: power outlet
- 4: power inlet
- 6: sensor
- 8: object
- 10: ultrasonic transmitter
- 12: ultrasonic receiver
- 14: power providing and/or cutting off unit
- 16: comparator unit
- 18: power plug
- 20: metal pins
- 21: metal object different to power plug
- 22: wireless data connection
- 24: mobile device
- 25: server
- 26: wireless data transmitter
- 28: speaker respectively acoustical signal unit
- 30: optical respectively visual display or signal unit
- 40: main board
- 100: multi socket

## Claims

1. System for controlling a power socket (1),
at least comprising:
a power socket (1) forming at least one power outlet (2) for receiving a corresponding power inlet (4),
a sensor (6) for sensing presence of an object (8), wherein the sensor (6) outputs sensing data and/or sensing signals representing presence of the object (8) in a sensing range of the sensor (6),
an ultrasonic transmitter (10) for emitting ultrasonic waves in dependency of the detection data and/or detection signals,
an ultrasonic receiver (12) for receiving ultrasonic waves outputted by the ultrasonic transmitter (10) and at least partially reflected by the object (8), wherein the ultrasonic receiver (12) outputs detection data and/or detection signals,
a power providing and/or cutting off unit (14) and
a comparator unit (16) for comparing the detection data and/or detection signals with reference data and/or reference signals, wherein the comparator unit (16) controls the power providing and/or cutting off unit (14),
wherein the power providing and/or cutting off unit (14) cuts of power flow in case detection data and/or detection signals differ from the reference data and/or reference signals
or
wherein the power providing and/or cutting off unit (14) starts enabling power flow to the power outlet (2) in case the detection data and/or detection signals match with the reference data and/or reference signals.

2. System according to claim 1,
**characterized in that**
reference data and/or reference signals represent a reflection pattern of ultrasonic waves, wherein the reflection pattern represents ultrasonic waves reflected by a reference object (8),
wherein the reference object (8) is a power plug (18), wherein the power plug (18) has at least two metal pins (20) or three metal pins or up to three metal pins.

3. System according to claim 2,
**characterized in that**
the sensor (6) is an inductive proximity sensor or metal detector or optical sensor, wherein the inductive proximity sensor or metal detector or optical sensor is part of the power socket (1) or wherein the inductive proximity sensor or metal detector or optical sensor is coupled to the power socket (1).

4. System according to claim 2,
**characterized in that**
the power plug (18) is a power plug (18) of the type: TIS 166-2549, SANS 164-2 3-pin, SANS 164-2 2-pin, NBR 14136 3-pin, NBR 14136 2-pin, IS 1293 and SANS 164-1, BS 546, CEI 23-50, 107-2-D1, SEV 1011:2009, Type 12 plug, IRAM 2073, GB 1002 and GB 2099.1, AS/NZS 3112, SI 32, BS 1363, IS 401 & IS 411, MS 589, SS 145, CEE 7/7 plug, CEE 7/4 plug, CEE 7/6 plug, IS 1293 and SANS 164-3, BS 4573, GOST 7396 C 1, CEE 7/2 plug, CEE 7/17 plug, CEE 7/16, JIS C 8303 Class I, NEMA 5-20, NEMA 5-15, JIS C 8303 Class II, NEMA 1-15 polarized or NEMA 1-15 unpolarized.

5. System according to claim 2,
**characterized in that**
the comparator unit (16) is an opamp circuit or comprises an opamp circuit.

6. System according to claim 2,
**characterized in that**
the power providing and/or cutting off unit (14) a relay circuit or comprises a relay circuit.

7. Method for controlling a power socket (1),
at least comprising the steps:
- Operating a sensor (6) for sensing presence of an object (8) in a sensing range, wherein the sensor (6) is part of the power socket (1) or coupled with the power socket (1),
- Operating an ultrasonic transmitter (10) in case the object (8) is sensed by the sensor (6), wherein the ultrasonic transmitter (10) and/or an ultrasonic receiver (12) is part of the power socket (1) or electrically coupled with the power socket (1), wherein the ultrasonic transmitter (10) emits ultrasonic waves,
- Operating the ultrasonic receiver (12), wherein the ultrasonic receiver (12) receives ultrasonic waves emitted by the ultrasonic transmitter and at least partly reflected by the object (8),
wherein the ultrasonic receiver (12) outputs detection data and/or detection signals representing the received ultrasonic waves,
- Operating a comparator unit (16), wherein the comparator unit (16) compares the detection data and/or detection signals outputted by the ultrasonic receiver (12) with reference data and/or reference signals,
- Operating a power providing and/or cutting off unit (14),
∘ wherein the power providing and/or cutting off unit (14) is part of the power socket (1) or electrically coupled with the power socket (1),
▪ wherein the power providing and/or cutting off unit (14) cuts off the power provided to at least one power outlet (2) of the power socket (1) in case the detection data and/or detection signals differ from the reference data and/or reference signals
or
wherein the power providing and/or cutting off unit (14) activates power delivery to at least one power outlet (2) of the power socket (1) in case the detection data and/or detection signals match with the reference data and/or reference signals.

8. Method for controlling a power socket (1),
at least comprising the steps:
- Operating a sensor (6) for sensing presence of an object (8) in a sensing range, wherein the sensor (6) is part of the power socket (1) or coupled with the power socket (1),
- Operating an ultrasonic transmitter (10) in case the object (8) is sensed by the sensor (6), wherein the ultrasonic transmitter (10) and/or an ultrasonic receiver (12) is part of the power socket (1) or electrically coupled with the power socket (1), wherein the ultrasonic transmitter (10) emits ultrasonic waves,
- Operating the ultrasonic receiver (12), wherein the ultrasonic receiver (12) receives ultrasonic waves emitted by the ultrasonic transmitter (10) and at least partly reflected by the object (8),
wherein the ultrasonic receiver (12) outputs detection data and/or detection signals representing the received ultrasonic waves,
- Operating a comparator unit (16), wherein the comparator unit (16) compares the detection data and/or detection signals outputted by the ultrasonic receiver with reference data and/or reference signals,
- Operating a power providing and/or cutting off unit (14),
∘ wherein the power providing and/or cutting off unit (14) is part of the power socket (1) or electrically coupled with the power socket (1),
▪ wherein the power providing and/or cutting off unit (14) enables power provided to at least one power outlet (2) of the power socket (1) in case the detection data and/or detection signals match with the reference data and/or reference signals
or
wherein the power providing and/or cutting off unit (14) prevents activation of power delivery to the power outlet (1), in case the detection data and/or detection signals differ from the reference data and/or reference signals.

9. Method according to claim 7 or 8,
**characterized in that**
reference data and/or reference signals represent a reflection pattern of ultrasonic waves, wherein the reflection pattern represents ultrasonic waves reflected by an reference object (8), wherein the reference object is a power plug (18), wherein the power plug (18) has at least or exactly two metal pins (20) or three metal pins or up to three metal pins.

10. Method according to claim 9,
**characterized in that**
the power plug (1) is a power plug (1) of the type: TIS 166-2549, SANS 164-2 3-pin, SANS 164-2 2-pin, NBR 14136 3-pin, NBR 14136 2-pin, IS 1293 and SANS 164-1, BS 546, CEI 23-50, 107-2-D1, SEV 1011:2009, Type 12 plug, IRAM 2073, GB 1002 and GB 2099.1, AS/NZS 3112, SI 32, BS 1363, IS 401 & IS 411, MS 589, SS 145, CEE 7/7 plug, CEE 7/4 plug, CEE 7/6 plug, IS 1293 and SANS 164-3, BS 4573, GOST 7396 C 1, CEE 7/2 plug, CEE 7/17 plug, CEE 7/16, JIS C 8303 Class I, NEMA 5-20, NEMA 5-15, JIS C 8303 Class II, NEMA 1-15 polarized or NEMA 1-15 unpolarized.

11. Method according to claim 9,
**characterized in that**
the sensor (6) is an inductive proximity sensor or metal detector or optical sensor, wherein the inductive proximity sensor or metal detector or optical sensor is part of the power socket (1) or wherein the inductive proximity sensor or metal detector or optical sensor is coupled to the power socket (1).

12. Method according to claim 9,
**characterized by** the step:
Outputting of an acoustic signal in case power is cut off by the power providing and/or cut off unit (14) and/or outputting an optical signal in case power is cut off by the power providing and/or cut off unit (14).

13. Method according to claim 9,
**characterized by** the step:
Outputting an acoustic signal in case the power delivery is activated and/or outputting an optical signal in case the power delivery is activated.

14. Method according to claim 9,
**characterized by** the step:
Transmitting via a wireless data connection (22) to a mobile device (24), in particularly a smart phone or Tablet PC or smart watch, and/or a server unit (25) alert data in case the power providing and/or cutting unit (14) cuts of providing power to the power socket (1), wherein the power socket (1) is coupled with a wireless data transmitter (26), in particularly a Bluetooth transmitter or a WLAN transmitter, or wherein the power socket (1) comprises the wireless data transmitter (26), in particularly a Bluetooth transmitter or a WLAN transmitter,
or
transmitting via a wireless data connection (22) to a mobile device (24), in particularly a smart phone or Tablet PC or smart watch, and/or a server unit connecting data in case the power providing and/or cutting off unit (14) provides power to the power socket (1), wherein the power socket (1) is coupled with a wireless data transmitter (26), in particularly a Bluetooth transmitter or a WLAN transmitter, or wherein the power socket (1) comprises a wireless data transmitter (26), in particularly a Bluetooth transmitter or a WLAN transmitter.

15. Power socket (1) comprising
a sensor (6) for sensing presence of an object (8), wherein the sensor (6) outputs sensing data and/or sensing signals representing presence of the object (8) in a sensing range of the sensor (6) in case the object (8) is sensed in the sensing range,
an ultrasonic transmitter (10) for emitting ultrasonic waves in dependency of the detection data and/or detection signals,
an ultrasonic receiver (12) for receiving ultrasonic waves outputted by the ultrasonic transmitter (10) and at least partially reflected by the object (8), wherein the ultrasonic receiver (12) outputs detection data and/or detection signals,
a power providing and/or cutting off unit (14) and
a comparator unit (16) for comparing the detection data and/or detection signals with reference data and/or reference signals, wherein the comparator unit (16) controls the power providing and/or cutting off unit (14),
wherein the power providing and/or cutting off unit (14) cuts of power flow in case detection data and/or detection signals differ from the reference data and/or reference signals
or
wherein the power providing and/or cutting off unit (14) starts enabling power flow to the power outlet in case the detection data and/or detection signals match with the reference data and/or reference signals.
